(19) **Europäisches Patentamt / European Patent Office / Office européen des brevets**

(11) **EP 4 516 722 A1**

(12) # EUROPEAN PATENT APPLICATION
published in accordance with Art. 153(4) EPC

(43) Date of publication:
05.03.2025 Bulletin 2025/10

(21) Application number: 23791736.4

(22) Date of filing: 10.04.2023

(51) International Patent Classification (IPC):
$B81B\ 1/00^{(2006.01)}$     $B81C\ 1/00^{(2006.01)}$
$G01N\ 37/00^{(2006.01)}$     $G03G\ 9/08^{(2006.01)}$
$G03G\ 9/087^{(2006.01)}$     $G03G\ 9/097^{(2006.01)}$

(52) Cooperative Patent Classification (CPC):
B81B 1/00; B81C 1/00; G01N 37/00; G03G 9/08;
G03G 9/087; G03G 9/097

(86) International application number:
PCT/JP2023/014591

(87) International publication number:
WO 2023/204087 (26.10.2023 Gazette 2023/43)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
KH MA MD TN

(30) Priority: 23.04.2022 JP 2022071208
15.03.2023 JP 2023040811

(71) Applicant: Canon Kabushiki Kaisha
Tokyo 146-8501 (JP)

(72) Inventors:
• TANAKA, Masanori
Tokyo 146-8501 (JP)

• YAMAMOTO, Takeshi
Tokyo 146-8501 (JP)
• MIYAZAKI, Keiji
Tokyo 146-8501 (JP)
• FUKATSU, Makoto
Tokyo 146-8501 (JP)
• MIURA, Jun
Tokyo 146-8501 (JP)
• MAEDA, Harunobu
Tokyo 146-8501 (JP)
• ENOKIDO, Fuka
Tokyo 146-8501 (JP)

(74) Representative: TBK
Bavariaring 4-6
80336 München (DE)

(54) **MICROCHANNEL DEVICE AND METHOD FOR PRODUCING SAME**

(57) A micro flow passage device in which a flow passage wall has high hydrophobicity and high cracking resistance is provided. In the micro flow passage device, a flow passage interposed between a flow passage wall is formed in the interior of a porous substrate, a flow-passage-wall-forming material constituting the flow passage wall contains a thermoplastic resin and a wax, X < Y where an abundance ratio of the wax in the flow passage wall on the surface side of the porous substrate is denoted by X, and an abundance ratio of the wax present in a pore in the interior of the porous substrate is denoted by Y, a content of the wax in the total flow-passage-wall-forming material is 13.1% by mass or more and 70.0% by mass or less, and $SP(B) - SP(W) \geq 0.6$ where an SP value of the wax is denoted by $SP(W)$ $[cal/cm^3]^{1/2}$, and an SP value of the thermoplastic resin is denoted by $SP(B)$ $[cal/cm^3]^{1/2}$.

FIG. 1A

EP 4 516 722 A1

(Cont. next page)

# FIG. 1B

# FIG. 1C

**Description**

Technical Field

The present disclosure relates to a micro flow passage device in which a micro flow passage is formed in the interior of a porous substrate and a method for manufacturing the same.

Background Art

In recent years, development of a micro flow passage device capable of efficiently (very small amount, rapid, and simple) performing biochemical analysis in a chip by utilizing a micro-sized fine flow passage has attracted attention in wide fields. Specifically, the micro flow passage device has attracted attention in wide fields of not only biochemical research but also medicine, drug discovery, health care, environment, food, and the like. In particular, a paper micro analysis chip based on paper provides advantages of being lightweight and low-cost compared with devices in the related art, no need for using a power supply, and in addition, high disposability. Consequently, there are expectations as an inspection device in medical services in developing countries and remote areas where medical equipment is not sufficiently prepared and at disaster sites, and at air terminals and the like where infections must be prevented from spreading at the water's edge. In addition, attention is attracted as a health care device capable of controlling and monitoring the health state by oneself due to a low price and ease of handling.

A micro analysis chip in which a micro-sized fine flow passage is formed on glass or silicon by using a photolithographic method, a metal mold, or the like and in which pretreatment of a sample, agitation, mixing, reaction, and detection are performed on one chip was developed during the first half of the 1990's. As a result, downsizing of an inspection system, rapid analysis, and reductions in a specimen, a reagent, and a liquid waste were realized. The micro flow passages produced by a technology of photolithography have very high precision. On the other hand, the production cost is very high, incineration is difficult, and, therefore, the disposability is poor. In addition, when an inspection liquid is fed into a flow passage, incidental equipment such as a syringe pump is required. Therefore, the micro flow passages have been restrictively used in a well-equipped environment and have been used mainly in biochemical research institutions.

Regarding these problems, a paper micro analysis chip is usable at a low cost and in an environment without electricity since an inexpensive material such as paper or cloth is used as a substrate and since a capillary phenomenon of the material itself being utilized enables a specimen or an inspection liquid to be driven. In addition, the paper micro analysis chip exhibits ease of carrying (distribution) and high disposability (disposal is completed by only incineration). Further, maintenance of the apparatus being unnecessary enables any one (even an elderly person or a child having no knowledge) to readily realize diagnosis based on POC (point of care) at low cost at any place (even a place without a power supply and regardless of a place). Therefore, research and development on the paper micro flow passage device are currently performed aiming at various infectious diseases and specific diseases and health care (chronic disease management and health management) in global research institutions.

Since the micro flow passage device uses a liquid as a specimen or an inspection liquid, a material constituting a flow passage is required to have high hydrophobicity to suppress the liquid soaking into a flow passage wall and to suppress the flow passage wall from swelling due to absorption of water during use of the device in a high-humidity environment. In particular, the hydrophobicity of a side surface portion on the flow passage side of the flow passage wall is important and has a large influence on the flow rate of the specimen and soaking into the flow passage wall.

PTL 1 proposes a micro flow passage device in which a flow passage wall is formed in a porous layer (paper or the like) by using a wax printer including a phase-change ink. However, when the ink is used, it is difficult to form a fine flow passage capable of obtaining a stable flow rate since soaking tends to occur.

In addition, when formation of a protective film such as a laminate film is intended to protect the produced micro flow passage device, the wax is not limited to being compatible with an adhesive layer of the laminate film, and peeling may occur since a bonding effect is not obtained. In this regard, the micro flow passage device including no protective layer is not limited to being adopted as a device having, for example, a roll-like shape with curvature since there is a concern that cracking tends to occur so as to cause leakage of a specimen.

Citation List

Patent Literature

PTL 1: Japanese Patent Laid-Open No. 2012-37511

Summary of Invention

Technical Problem

It is an object of an aspect of the present disclosure to provide a micro flow passage device in which a flow passage wall has high hydrophobicity and high cracking resistance. It is an object of another aspect of the present disclosure to provide a method for manufacturing a micro flow passage device in which a flow passage wall has high hydrophobicity and high cracking resistance.

Solution to Problem

An aspect of the present invention provides a micro flow passage device in which a flow passage interposed between a flow passage wall is formed in the interior of a porous substrate,

wherein a flow-passage-wall-forming material constituting the flow passage wall contains a thermoplastic resin and a wax,

$$X < Y$$

where an abundance ratio of the wax in the flow passage wall on the surface side of the porous substrate is denoted by X, and an abundance ratio of the wax in the interior of the porous substrate is denoted by Y, a content of the wax in the total flow-passage-wall-forming material is 13.1% by mass or more and 70.0% by mass or less, and

$$SP(B) - SP(W) \geq 0.6$$

where an SP value of the wax is denoted by $SP(W)$ $[cal/cm^3]^{1/2}$, and an SP value of the thermoplastic resin is denoted by $SP(B)$ $[cal/cm^3]^{1/2}$,

Another aspect of the present invention provides a method for manufacturing a micro flow passage device in which a flow passage interposed between a flow passage wall is formed in the interior of a porous substrate, the method including:

forming a flow passage pattern on a surface of the porous substrate by placing a flow-passage-wall-forming material containing a thermoplastic resin and a wax on the surface of the porous substrate by using an electrophotographic system and
forming a flow passage wall in the interior of the porous substrate by melting the wax contained in the flow passage pattern with heat so that the wax permeates the interior of the porous substrate,
wherein a content of the wax in the total flow-passage-wall-forming material is 13.1% by mass or more and 70.0% by mass or less, and

$$SP(B) - SP(W) \geq 0.6$$

where an SP value of the wax is denoted by $SP(W)$ $[cal/cm^3]^{1/2}$ and an SP value of the thermoplastic resin is denoted by $SP(B)$ $[cal/cm^3]^{1/2}$.

Advantageous Effects of Invention

According to an aspect of the present disclosure, a micro flow passage device in which a flow passage wall has high hydrophobicity and high cracking resistance is provided. According to another aspect of the present disclosure, a micro flow passage device in which a flow passage wall has high hydrophobicity and high cracking resistance is provided.

Brief Description of Drawings

[Fig. 1A] Fig. 1A is a schematic sectional view illustrating a state (before heating) in which a flow-passage-wall-forming particle T is placed on a surface of a porous substrate S1 in Example 1.

[Fig. 1B] Fig. 1B is a schematic sectional view illustrating a state (after heating) in which a molten wax permeated into the interior of the porous substrate S1.

[Fig. 1C] Fig. 1C is an enlarged sectional view of a portion of the micro flow passage device formed by permeation of a molten wax.

[Fig. 2] Fig. 2 is a configuration diagram illustrating an image-forming unit 100 in Example 1.

[Fig. 3] Fig. 3 is a configuration diagram illustrating a process cartridge P in Example 1.

[Fig. 4] Fig. 4 is a block diagram schematically illustrating the control manner of the image-forming unit 100 in Example 1.

[Fig. 5A] Fig. 5A is a flow passage pattern diagram in Example 1.

[Fig. 5B] Fig. 5B is a schematic sectional view illustrating a state (after heating) in which a molten wax permeated into the interior of the porous substrate S1.

[Fig. 5C] Fig. 5C is an enlarged sectional view of a portion of the micro flow passage device formed by permeation of a molten wax.

[Fig. 6A] Fig. 6A is a schematic sectional view illustrating a state in which colored water is dripped on a flow passage of a device provided with a flow passage wall.

[Fig. 6B] Fig. 6B is a schematic sectional view illustrating a state in which colored water is dripped on a flow passage of a device from which a flow passage wall was removed.

Description of Embodiments

Exemplary embodiments according to the present disclosure will be described below with reference to the drawings. In this regard, the following embodiments are exemplifications, and the present disclosure is not limited to the contents of the embodiments. Regarding the following drawings, constituent elements unnecessary for explanation of the embodiments are omitted from the drawings.

Regarding the micro flow passage device according to the present disclosure, a flow passage interposed between a flow passage wall is formed in the interior of a porous substrate.

The flow passage wall contains a thermoplastic resin and a wax. In this regard, the flow passage wall includes both a portion in the interior of the porous substrate, the portion being formed by a component that permeated into the porous substrate, and a portion formed on the porous substrate surface, the portion being formed by a component present on the porous substrate surface.

A SP value of the wax is lower than a SP value of the thermoplastic resin.

An abundance ratio of the wax in the interior of the porous substrate is higher than an abundance ratio of the wax on the surface side of the porous substrate.

"Abundance ratio of the wax" means an area ratio of the wax in a flow-passage-wall-forming material portion when a cross section of the micro flow passage device is observed.

"The surface side of the porous substrate" means the outside (air layer side) of the outermost surface of the porous substrate (interface between the porous substrate and the air layer). In this regard, when the porous substrate is in contact with something, the interface means an interface to a member in contact with the porous substrate.

"Interior of the porous substrate" means the inside (porous substrate side) of the outermost surface of the porous substrate.

"An abundance ratio of the wax in the interior of the porous substrate is higher than an abundance ratio of the wax on the surface side of the porous substrate" means

$$X < Y$$

where an abundance ratio of the wax on the surface side of the porous substrate is denoted by X, and an abundance ratio of the wax present in a pore in the interior of the porous substrate is denoted by Y.

In the present disclosure, a flow passage wall is formed in the interior of the porous substrate by a flow passage pattern, which is formed by placing a flow-passage-wall-forming particle on a surface of the porous substrate by using an electrophotographic system, being melted due to heat and permeating the interior of the porous substrate.

<Flow-passage-wall-forming material>

The flow-passage-wall-forming material contains a thermoplastic resin and a wax (oils and fats).

The flow passage pattern is formed on the surface of the porous substrate by using the flow-passage-wall-forming particle composed of the flow-passage-wall-forming material. The flow passage pattern is melted due to heat so that the flow passage wall is formed by the flow-passage-wall-forming material permeating the interior of the porous substrate.

A content of the wax in the total flow-passage-wall-forming material is set to be 13.1% by mass or more and 70.0% by mass or less.

"Content of the wax in the flow-passage-wall-forming material" means a mass ratio of the wax contained in the total flow-passage-wall-forming material. That is, the content is a mass ratio of the wax in a total of the flow-passage-wall-forming material present in a pore in the interior of the porous substrate and the flow-passage-wall-forming material present on the surface of the porous substrate.

The reason the content of the wax is set to be within the above-described range is that when the content of the wax is less than 13.1% by mass, the amount of wax W supplied to the porous substrate S1 is insufficient and the flow passage wall is unable to be formed and that when the content of the wax is more than 70.0% by mass, it is difficult to form the flow passage pattern by the electrophotographic system in an image-forming process.

"Content of the wax in the flow-passage-wall-forming material" may be measured as described below. Ten 1-cm-square samples are prepared by cutting from each of the flow passage portion provided with no flow passage wall, that is, a portion of the porous substrate S1 itself, and a portion provided with the flow passage wall. Subsequently, hexane is dripped to a portion provided with the flow passage wall while suctioning is performed so that the wax is dissolved in hexane and removed. The mass of the wax is calculated from a mass difference between before and after the hexane washing. Next, the mass of the thermoplastic resin is calculated from a mass difference between the mass after the wax is removed and the mass of the portion of the porous substrate S1 itself. The content is calculated from the resulting mass of the wax and the resulting mass of the thermoplastic resin.

In this regard, materials satisfying the following formula are used, where an SP value of the wax is denoted by $SP(W)$ $[cal/cm^3]^{1/2}$, and an SP value of the thermoplastic resin is denoted by $SP(B)$ $[cal/cm^3]^{1/2}$.

$$SP(B) - SP(W) \geq 0.6$$

The wax having a relatively low SP value being present in the interior of the porous substrate enables the flow passage wall to have favorable hydrophobicity.

In addition, when the difference between $SP(B)$ and $SP(W)$ is less than 0.6, since the thermoplastic resin B and the wax X tends to become compatible, the wax W is not readily separated from the flow-passage-wall-forming material, a sufficient amount of wax W is unable to reach the porous substrate S1 and unable to form the flow passage wall.

In this regard, when the difference between the SP value of the thermoplastic resin B and the SP value of the wax W increases, the wax W is readily separated from the flow-passage-wall-forming material and readily permeates the interior of the porous substrate S1, and, therefore, it is favorable that materials satisfying the following formula be used.

$$SP(B) - SP(W) \geq 1.0$$

During a heating process described later, the wax W melted due to heat is isolated and goes outside the flow-passage-wall-forming particle T. The reason for this that the wax W having a low SP value tends to be present on the outermost surface side of the flow-passage-wall-forming particle T due to the difference in the surface free energy between the thermoplastic resin B and the wax W. Consequently, performing heating enables the wax to be separated from the thermoplastic resin B and actively permeate the interior of the porous substrate S1 and enables the thermoplastic resin layer to be formed on the surface of the porous substrate S1.

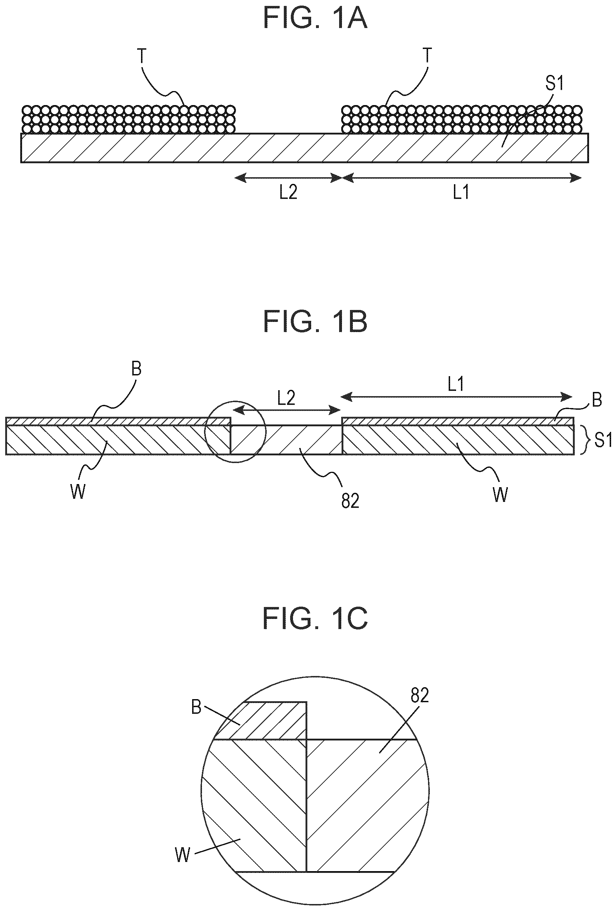

As illustrated in Fig. 1C, the flow passage wall formed in the interior of the porous substrate S1 due to the wax has high hydrophobicity because of the characteristics of the wax W and enables a risk of a liquid such as a specimen oozing outside a flow passage 82 (inside the flow passage wall) to be reduced.

-Thermoplastic resin-

There is no particular limitation regarding the thermoplastic resin, and known thermoplastic resins described below may be used: polyester resins, vinyl-based resins, acrylic resins, styrene acrylic resins, polyethylenes, polypropylenes, polyolefins, ethylene-vinyl acetate copolymer resins, ethylene-acrylate copolymer resins, and the like.

Of the thermoplastic resins, polyester resins or styrene acrylic resins are favorable, and styrene acrylic resins are more favorable.

Regarding the polyester resins, known polyester resins may be used.

Specific examples of the method for manufacturing the polyester resin include a method described below: a method in which a dibasic acid or a derivative thereof and a dihydric alcohol, that are indispensable, and as the situation demands, a trivalent or higher polybasic acid or a derivative thereof (carboxylic halide, ester, acid anhydride), a monobasic acid, a trihydric or higher alcohol, a monohydric alcohol, and the like are subjected to a dehydration condensation reaction.

Examples of the dibasic acid include the following materials: aliphatic dibasic acids, such as maleic acid, fumaric acid, itaconic acid, oxalic acid, malonic acid, succinic acid, dodecylsuccinic acid, dodecenylsuccinic acid, adipic acid, azelaic acid, sebacic acid, and decane-1,10-dicarboxylic acid; and aromatic dibasic acids, such as phthalic acid, tetrahydrophthalic acid, hexahydrophthalic acid, tetrabromophthalic acid, tetrachlorophthalic acid, HET acid, himic acid, isophthalic acid, terephthalic acid, and 2,6-naphthalene dicarboxylic acid; and the like.

In addition, examples of the derivative of the dibasic acid include carboxylic halides, esterified products, acid anhydrides, and the like of the above-described aliphatic dibasic acids and aromatic dibasic acids.

On the other hand, examples of the dihydric alcohol include the following materials: acyclic aliphatic diols, such as ethylene glycol, 1,2-propanediol, 1,3-propanediol, 1,4-butanediol, 1,5-pentanediol, 1,6-hexanediol, diethylene glycol, dipropylene glycol, triethylene glycol, and neopentyl glycol; bisphenols, such as bisphenol A and bisphenol F; bisphenol A alkylene oxide adducts, such as bisphenol A ethylene oxide adducts and bisphenol A propylene oxide adducts; aralkylene glycols, such as xylylene diglycol; and the like.

Examples of the trivalent or higher polybasic acid or an anhydride thereof include trimellitic acid, trimellitic anhydride, pyromellitic acid, and pyromellitic anhydride.

Examples of the polymerizable monomer capable of forming the styrene acrylic resin include the following materials: styrene-based monomers, such as styrene, $\alpha$-methylstyrene, and divinylbenzene; unsaturated carboxylic acid esters, such as methyl acrylate, butyl acrylate, methyl methacrylate, 2-hydroxyethyl methacrylate, t-butyl methacrylate, and 2-ethylhexyl methacrylate; unsaturated carboxylic acids, such as acrylic acid and methacrylic acid; unsaturated dicarboxylic acids, such as maleic acid; unsaturated dicarboxylic acids, such as maleic anhydride; nitrile-based vinyl monomers, such as acrylonitrile; halogen-containing vinyl monomers, such as vinyl chloride; nitro-based vinyl monomers, such as nitrostyrene; and the like. One type of these may be used alone, or a plurality of types thereof may be used in combination.

Regarding the styrene acrylic resin, when a copolymer of the styrene-base polymerizable monomer and the acrylic acid ester or the methacrylic ester is formed, a crosslinking agent may be added as the situation demands. Examples include the following materials.

Divinylbenzene, bis(4-acryloxypolyethoxyphenyl) propane, ethylene glycol diacrylate, 1,3-butylene glycol diacrylate, 1,4-butanediol diacrylate, 1,5-pentanediol diacrylate, 1,6-hexanediol diacrylate, neopentyl glycol diacrylate, diethylene glycol diacrylate, triethylene glycol diacrylate, tetraethylene glycol diacrylate, polyethylene glycol #200 diacrylate ($CH_2=CHCOO(CH_2CH_2O)_n OCCH=CH_2$, n = 4, molecular weight of 308), polyethylene glycol #400 diacrylate ($CH_2=CHCOO(CH_2CH_2O)_n OCCH=CH_2$, n = 9, molecular weight of 508), each diacrylate of polyethylene glycol #600 ($CH_2=CHCOO(CH_2CH_2O)_n OCCH=CH_2$, n = 14, molecular weight of 708), dipropylene glycol diacrylate, polypropylene glycol diacrylate, and polyester-type diacrylate (MANDA, Nippon Kayaku Co., Ltd.) and methacrylates in which the above-described acrylate is changed to methacrylate.

Examples of the polyfunctional, cross-linkable monomer include the following materials: pentaerythritol triacrylate, trimethylolethane triacrylate, trimethylolpropane triacrylate, tetramethylolmethane tetraacrylate, oligoester acrylate or methacrylate thereof, 2,2-bis(4-methacryloxy·polyethoxyphenyl) propane, diacrylphthalate, triallyl cyanurate, triallyl isocyanurate, triallyl trimellitate, and diaryl chlorendate.

The weight average molecular weight (Mw) of a binder resin is within the range of preferably 3,000 or more and 500,000 or less, more preferably 5,000 or more and 300,000 or less, and further preferably 7,500 or more and 100,000 or less.

In this regard, because of relation to permeation into the base substrate described later, the storage elastic modulus G' favorably satisfies

G' > 14 Pa (160°C in Example 1)

at a heating process temperature in Example according to the present disclosure.

The storage elastic modulus G' indicates an elastic modulus of an object, and a lower value indicates larger deformation with respect to a certain load. That is, a low storage elastic modulus G' indicates that permeation more readily occurs when a permeation force due to a capillary phenomenon is applied to the porous substrate S1.

-Wax (oils and fats)-

There is no particular limitation regarding the material used as the wax according to the present disclosure, and known waxes which are used for a toner, described below, may be used.

Esters of a monohydric alcohol and an aliphatic carboxylic acid or esters of a monovalent carboxylic acid and an aliphatic alcohol, such as behenyl behenate, stearyl stearate, and palmityl palmitate; esters of a dihydric alcohol and an aliphatic carboxylic acid or esters of a divalent carboxylic acid and an aliphatic alcohol, such as dibehenyl sebacate and hexanediol dibehenate; esters of a trihydric alcohol and an aliphatic carboxylic acid or esters of a trivalent carboxylic acid and an aliphatic alcohol, such as glycerin tribehenate; esters of a tetrahydric alcohol and an aliphatic carboxylic acid or esters of a tetravalent carboxylic acid and an aliphatic alcohol, such as pentaerythritol tetrastearate and pentaerythritol tetrapalmitate; esters of a hexahydric alcohol and an aliphatic carboxylic acid or esters of a hexavalent carboxylic acid and an aliphatic alcohol, such as dipentaerythritol hexastearate and dipentaerythritol hexapalmitate; esters of a polyhydric alcohol and an aliphatic carboxylic acid or esters of a polyvalent carboxylic acid and an aliphatic alcohol, such as polyglycerin behenate; natural ester waxes, such as carnauba wax and rice wax; petroleum-based waxes or derivatives thereof, such as paraffin wax, microcrystalline wax, and petrolatum; hydrocarbon waxes by the Fischer-Tropsch process or derivatives thereof; polyolefin waxes or derivatives thereof, such as polyethylene wax and polypropylene wax; higher aliphatic alcohols; fatty acids, such as stearic acid and palmitic acid; and acid amide waxes.

One type of these waxes may be used alone, or a plurality of types thereof may be used.

The weight average molecular weight of the wax is preferably 300 or more and 10,000 or less.

When the weight average molecular weight of the wax is less than 300, there is a concern that the permeability of the wax may be excessively large, oozing from the surface side of the flow passage wall portion may increase, a flow passage wall may be formed inside the flow passage, and the flow passage itself is narrowed.

When the weight average molecular weight of the wax is more than 10,000, there is a possibility that the wax tends to remain in the interior of the flow-passage-wall-forming material, and the wax does not appear on the surface of the flow passage wall portion opposing the flow passage.

<Method for calculating solubility parameter (SP value)>

The solubility parameter (SP value) is determined by using the Fedors equation (1).

The values of $\Delta ei$ and $\Delta vi$ below refer to "Evaporation energy and Molar volume (25°C) of Atom and Atomic group presented in Table 3 to Table 9 of Kotingu no Kisokagaku (basic science of coating), p. 54-57, 1986 (Maki Shoten)".

In this regard, the unit of the SP value is $[cal/cm^3]^{1/2}$ and is converted to a unit of $[J/m^3]^{1/2}$ based on 1 $[cal/cm^3]^{1/2}$ = $2.046 \times 10^3$ $[J/M^3]^{1/2}$.

$$\delta i = (Ev/V)^{1/2} = (\Delta ei/\Delta vi)^{1/2} \quad \text{Equation (1)}$$

Ev: evaporation energy
V: molar volume
$\Delta ei$: evaporation energy of atom or atomic group of i component
$\Delta vi$: molar volume of atom or atomic group of i component

<Image-forming unit>

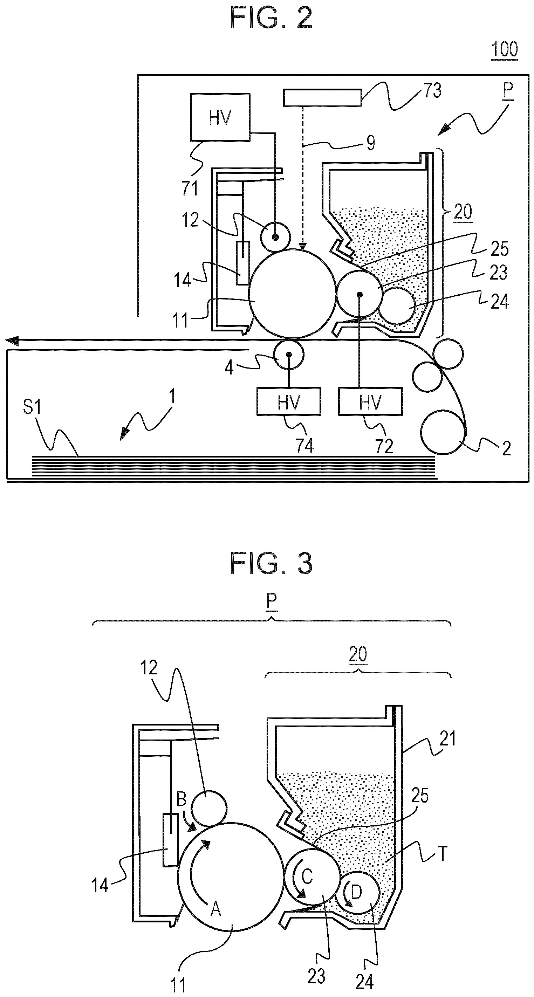

The configuration of an entire image-forming unit will be described with reference to Fig. 2, Fig. 3, and Fig. **4.**

Fig. 2 is a schematic sectional view illustrating the configuration of an image-forming unit 100 according to Example of the present disclosure and schematically illustrates each configuration.

Fig. 3 is a schematic sectional view illustrating a process cartridge P according to Example of the present disclosure.

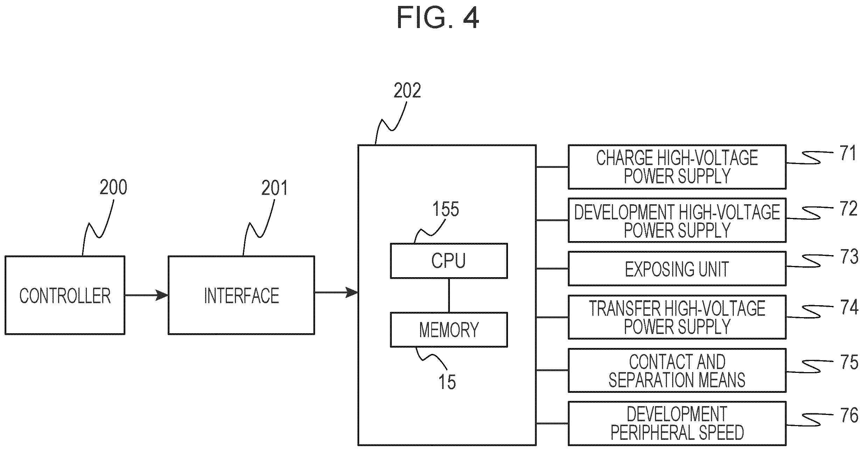

Fig. 4 is a block diagram schematically illustrating the control manner of key portions of the image-forming unit 100 in Example according to the present disclosure.

To begin with, the configuration of the image-forming unit, an image-forming process, and each member will be described. Each member according to the image-forming process will be described in conformity with the order in the image-forming process with reference to Fig. **2.**

The image-forming unit 100 is capable of storing the process cartridge P, and since exchange is performed on a process cartridge basis, ease of maintenance and convenience are ensured. The process cartridge P includes a photosensitive drum 11 as an image-bearing member. A charge roller 12, a developing apparatus 20, and a cleaning member 14 are disposed around the photosensitive drum 11. The charge roller 12 charges the surface of the photosensitive drum 11. The developing apparatus 20 develops an electrostatic latent image formed on the surface of the photosensitive drum 11 with a developer (flow-passage-wall-forming particle). The cleaning member 14 cleans the surface of the photosensitive drum 11. A voltage necessary for image formation is applied by a charge high-voltage power supply 71, a development high-voltage power supply 72, and a transfer high-voltage power supply 74 and is controlled by a control portion 202 (Fig. 4). In this regard, in the image-forming unit 100, the photosensitive drum 11 of the process cartridge P is driven by a motor M1 (not illustrated in the drawing), and the developing apparatus 20 of the process cartridge P is driven by a motor M2 (not illustrated in the drawing).

When image formation is started, a voltage of -946 V serving as a charge for image formation is applied to the charge roller 12 by the charge high voltage 71 serving as a voltage application portion so that the surface of the photosensitive drum 11 is uniformly charged to -460 V. A DC (direct current) voltage is applied to the charge roller 12, and the surface of the photosensitive drum 11 is uniformly charged to a charge potential Vd by discharge. In such an instance, Vd is referred to as a dark part potential and is -460 V.

After the surface of the photosensitive drum 11 is charged by the charge roller 12, the surface of the photosensitive drum 11 is irradiated with laser light 9 from an exposing unit 73. Regarding the surface of the photosensitive drum 11 irradiated with the laser light 9, the surface potential is changed to -100 V that is a light part potential Vl, and an electrostatic latent image is formed.

As illustrated in Fig. 4, a time-series electrical digital pixel signal of the image information that is input into a control portion 202 from the controller 200 through an interface 201 and is subjected to image processing is input into the exposing unit 73.

The exposing unit 73 includes a laser output portion to output the laser light 9 modulated in accordance with the input time-series electrical digital pixel signal, a rotary polygon mirror, an fθ lens, a reflecting mirror, and the like and performs main scanning exposure of the surface of the photosensitive drum 11 with the laser light 9. An electrostatic latent image in accordance with the image information is formed by the main scanning exposure and subscanning due to rotation of the photosensitive drum 11.

<Image (flow passage pattern)-forming process>

The image-forming unit 100 includes a contact and separation means 75 to control the position of the developing apparatus 20 and is capable of controlling the position of the developing apparatus 20 so that the position when the image is formed differs from the position when the image is not formed. The action of the contact and separation means 75 is controlled by the control portion 202 illustrated in Fig. 4.

After rotation of the photosensitive drum 11 is started, the developing apparatus 20 is moved so that a developing roller 23 serving as a developer-bearing member that has been separated from the photosensitive drum 11 is brought into contact with the photosensitive drum 11 by the contact and separation means 75.

Subsequently, the developing roller 23 is started to rotate in the direction of arrow C in Fig. 3 and a supply roller 24 serving as a developer (flow-passage-wall-forming particle) supply member is started to rotate in the direction of arrow D in Fig. 3 due to being driven by the motor M2 (not illustrated in the drawing) to which these are coupled respectively. Thereafter, the developer is supplied to the electrostatic latent image formed on the photosensitive drum 11, that is, the above-described Vl portion, by the developing roller 23 and development is performed by a voltage of -300 V serving as a developing voltage being applied to the developing roller 23 from the development high voltage 72 for the developing roller 23. In this regard, in such an instance, the ratio of the moving speed of the developing roller 23 surface to the moving speed of the photosensitive drum 11 surface (moving speed of developing roller 23 surface / moving speed of photosensitive drum 11 surface) is referred to as a development peripheral speed ratio. The development peripheral speed ratio being controlled enables the amount of the developer developed on the photosensitive drum 11 to be controlled. For example, when the development peripheral speed ratio is 2.5 and the developer on the developing roller 23 is entirely used for development of the electrostatic latent image on the photosensitive drum 11, the amount of the developer per unit area of the photosensitive drum 11 surface is 2.5 times the amount of the developer per unit area of the developing roller 23. In Example described later, to develop the developer in an amount suitable for forming a micro flow passage wall in the interior of the porous substrate S1, the development peripheral speed ratio is controlled by the speed of the motor M2.

The porous substrate S1 serving as a recording medium is placed on a paper feed tray 1 and is picked up one by one by a pick-up roller 2. The developed developer image is transferred to the porous substrate S1 serving as a recording medium due to a potential difference from transfer roller 4 to which +2000 V is applied by transfer high voltage 74. As described later, the porous substrate S1 is a sheet-like porous medium composed of a porous body. The transfer roller 4 includes an electrically conductive shaft core (hereafter also referred to as a core bar) and a semiconductive sponge that serves as a pressure-contact portion with respect to the photosensitive drum 11, that is an elastic body, and that contains NBR hydrin rubber as a primary component, and electric resistance is adjusted by using an ionic conductor. The outer diameter is 12.5 mm and the core bar diameter is 6 mm.

In this regard, the resistance value when 2 kV is applied is:

$1.0 \times 10^8 \, \Omega$ to $3.0 \times 10^8 \, \Omega$ in a normal-temperature normal-humidity environment at 23°C/relative humidity of 50%,
$0.5 \times 10^8 \, \Omega$ in a high-temperature high-humidity environment at 32°C/relative humidity of 80%, and
$8.0 \times 10^8 \, \Omega$ in a low-temperature low-humidity environment at 15°C/relative humidity of 10%,
where the resistance changes in accordance with the environment.

The porous substrate S1 to which the developer image was transferred is discharged with the developer image up in the gravity direction to the outside of the image-forming unit. In this regard, the developer that is not transferred is scraped from the photosensitive drum 11 passed the transfer roller 4 by a cleaning member 14 in contact with the photosensitive drum 11. Image formation is successively performed by repeating the charging by the charge roller 12 and the subsequent process.

<Flow passage>

A liquid such as a specimen in the porous layer is repelled by the flow passage wall (details will be described below), the liquid is confined in a predetermined region surrounded by the flow passage wall, and a capillary phenomenon of the porous layer enables a sample liquid to flow in the flow passage.

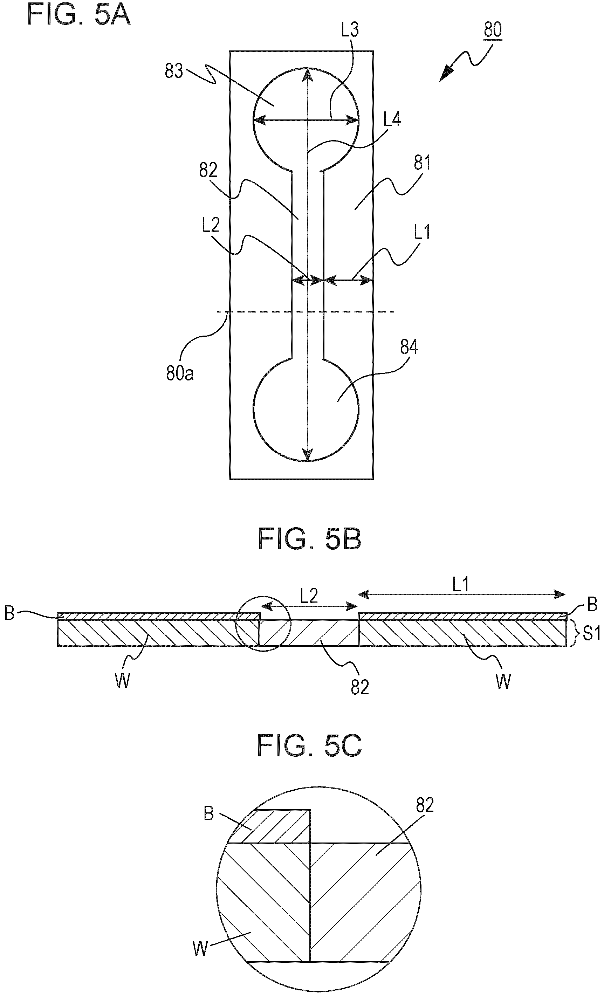

In Example according to the present disclosure, a flow passage pattern 80 illustrated in Fig. 5A was formed in a porous substrate S1 by using an image-forming unit 100.

Fig. 5B is a schematic sectional view at a position indicated by a broken line 80a in Fig. 5A. Fig. 5C is an enlarged diagram of a portion in Fig. 5B.

To use the flow passage as a micro flow passage device, a flow-passage-wall-forming particle image 81 surrounding each of a reagent portion 83, an inspection liquid portion 84, and a flow passage 82 was formed. The reagent portion 83 is a portion to which a reagent is attached, the inspection liquid portion 84 is a portion to which an inspection liquid (sample liquid) is attach, and the flow passage 82 is to connect the reagent portion 83 to the inspection liquid portion 84. The width L1 of the flow-passage-wall-forming particle image 81 at a portion in which the flow passage 82 is interposed was set to be 4 mm, and the width L2 of the flow passage 82 was set to be 1.5 **mm.** In addition, the diameters L3 of the reagent portion 83 and the inspection liquid portion 84 were set to be 7 mm, and the longest portion L4 of the flow passage was set to be 40 **mm.** Regarding an example of use as the micro flow passage device, a reagent that causes a color reaction being attached to the reagent portion 83 and, thereafter, an inspection liquid being attached to the inspection liquid portion 84 enable the inspection liquid to diffuse to the reagent portion 83 through the flow passage 82 and enable whether the color reaction occurs to be inspected. However, the shape, the size, and the like of the flow passage pattern are not limited to these, as a matter of course. The shape may include a combination of a straight line and a curved line and a branch, and the width of the flow passage may be changed in the middle of the flow passage.

<Flow passage wall>

The flow passage wall is composed of the flow-passage-wall-forming material and has high hydrophobicity. In particular, to function as the flow passage, the hydrophobicity of the side surface portion on the flow-passage side of the flow passage wall is important and has a significant influence on the flow rate of the specimen and soaking into the flow passage wall.

Consequently, in Example according to the present disclosure, the flow passage wall is formed by making a wax having high hydrophobicity actively permeate the porous substrate S1.

<Porous substrate>

Materials having appropriate porosity and hydrophilicity are suitable for the porous substrate S1. Regarding the porous structure, materials having, for example, an interconnected-cell-like or mesh-like (nanofiber or the like) structure are favorable, and examples include filter paper, normal paper, fine quality paper, watercolor paper, Kent paper, synthetic paper, synthetic resin porous film, cloth, and textile goods. Of these, filter paper is favorable from the viewpoint of having high porosity and favorable hydrophilicity.

The porosity may be appropriately selected in accordance with the purpose and is preferably 20% to 90%. When the porosity is more than 90%, the strength of the substrate is not limited to being maintained, and when the porosity is less than 20%, the permeability of the sample liquid may deteriorate.

The hydrophilicity is a property necessary for enabling a water-containing biological liquid, such as blood, urine, or saliva, serving as a sample liquid to diffuse in the substrate.

In Example according to the present disclosure, Whatman Qualitative Filter Paper Grade 1 was used as the porous substrate S1.

The basis weight and the like of the porous substrate S1 used in Example according to the present disclosure are presented in Table 1.

The apparent density ($g/cm^3$) was calculated based on (basis weight ($g/m^2$) / thickness (mm) $\times$ 1,000), and the porosity (%) was calculated based on ((true density - apparent density) / true density $\times$ 100).

[Table 1]

| | Basis weight (g/m$^2$) | Thickness ($\mu$m) | Apparent density (g/cm$^3$) | True density (g/cm$^3$) | Porosity (%) |
|---|---|---|---|---|---|
| Whatman Grade 1 | 87 | 180 | 0.48 | 1.5 | 68 |

<Amount of placed flow-passage-wall-forming material>

The flow passage pattern is formed on Whatman Qualitative Filter Paper Grade 1 serving as the porous substrate S1 by using the flow-passage-wall-forming particle T. In such an instance, the amount of placed flow-passage-wall-forming particle T was set to be 5.6 g/m$^2$.

The amount of placement is not limited to the above-described value since the most suitable condition is changed in accordance with the thickness of the porous substrate S1 and the method and the time of the heating process.

<Heating process>

The porous substrate S1 printed with the flow passage pattern 80 is subjected to a heating process by using a heating unit (not illustrated in the drawing). Due to the heating process, the flow-passage-wall-forming material is melted, a thermoplastic resin B and a wax W in the flow-passage-wall-forming material are separated from each other, and the separated wax permeates the porous substrate S1 so that a micro flow passage device having a flow passage surrounded by a hydrophobic wall is formed.

Therefore, the heating temperature has to be a temperature at which the flow-passage-wall-forming material is melted, and the wax W separated from the thermoplastic resin B permeates the porous substrate S1. In the configuration of Example described later, the flow-passage-wall-forming material began to melt at 140°C or higher, and the wax permeated the porous substrate S1.

The heating time has to be a time in which a molten·separated wax completely permeates in the thickness direction of the porous substrate S1.

An oven may be adopted as the heating unit. However, the heating system is not limited to this, and a far-infrared heater, a hot plate, or the like may be used. The heating condition may be appropriately selected in accordance with the physical properties of the flow-passage-wall-forming material and the porous substrate S1.

The heating process under the above-described condition will be described with reference to Fig. 1A and Fig. 1B.

Regarding drawings illustrating the flow-passage-wall-forming material before or after heating, Fig. 1A to Fig. 1C are schematic sectional views at a position indicated by a broken line 80a in Fig. 5A. Fig. 1A is a sectional view illustrating a section before heating, and Fig. 1B is a sectional view illustrating a section after heating. Fig. 1C is an enlarged diagram of a portion in Fig. 1B.

As illustrated in Fig. 1A, the flow-passage-wall-forming particle T before heating is in a state of only being attached to the surface of the porous substrate S1.

Thereafter, the flow-passage-wall-forming particle T is melted by heating, and the wax W is separated from the thermoplastic resin B. The thermoplastic resin B remains on the surface of the porous substrate S1, and the wax W permeates the interior of the porous substrate S1 due to a capillary phenomenon with respect to the porous substrate S1.

As illustrated in Fig. 1B, after heating, the hydrophobic wax W permeates in the thickness direction of the porous substrate S1, and the flow passage 82 interposed between the wax W is formed in the porous substrate S1.

As described above, an apparatus for producing a micro flow passage device having a flow passage surrounded by a flow passage wall in the porous substrate S1 is formed by combining the image-forming unit 100 and the heating unit.

<Cross section of flow passage wall>

The flow-passage-wall-forming particle T contains the thermoplastic resin B and the wax W. In Example according to the present disclosure, as described above, due to the heating process, the flow-passage-wall-forming particle T is melted, the thermoplastic resin B and the wax W are separated from each other, and the wax is made to permeate the porous substrate S1 so that the flow passage wall is formed in the interior of the porous substrate S1. Regarding the flow passage wall, it is favorable that only the wax permeate the interior of the porous substrate S1 from the viewpoint of the hydrophobicity, and it is favorable that the thermoplastic resin B remain on the surface of the porous substrate S1 from the viewpoint of protecting the surface of the porous substrate S1. Consequently, it is favorable that the storage elastic modulus G' of the thermoplastic resin B be set to be the above-described value so as to prevent permeation into the substrate from occurring.

The present disclosure will be described below in detail with reference to Examples and Comparative examples, but the present disclosure is not limited to Examples. In this regard, "part" or "%" in the description is on a mass basis, unless otherwise specified.

[Example 1]

In Example 1, a micro flow passage device was produced by using a flow-passage-wall-forming particle T1 containing a thermoplastic resin B1 and a wax W1.

The flow-passage-wall-forming particle T1 was produced as a particle having a weight average particle diameter of 7 $\mu$m by a known suspension polymerization method. A styrene acrylic resin was used as the thermoplastic resin B1, and FNP90 was used as the wax W1. The flow-passage-wall-forming particle T1 in which the SP value of the wax (SP(W)) was lower than the SP value of the thermoplastic resin (SP(B)) and a $\triangle$SP value (= SP(B) - SP(W)) was 1.41 was produced.

<Production of flow-passage-wall-forming particle T1>

[Polymerizable monomer composition preparation step]

After the following composition was mixed, dispersion was performed for 3 hours by using a ball mill.

| | |
|---|---|
| Styrene | 70.0 parts by mass |
| n-Butyl acrylate | 30.0 parts by mass |
| Divinyl benzene | 0.3 parts by mass |
| Polyester resin | 5.0 parts by mass |

(polycondensation product of propylene-oxide-modified bisphenol A and isophthalic acid (glass transition temperature of 65°C, weight average molecular weight (Mw) of 10,000, number average molecular weight (Mn) of 6,000)) FNP90 wax (NIPPON SEIRO CO., LTD., hydrocarbon wax, weight average molecular weight of 771) 20.0 parts by mass

The above-described material was maintained at 65°C and was homogeneously dissolved and dispersed by using T. K. Homo Mixer (produced by Tokushu Kika Kogyo Co., Ltd.) at 500 rpm so that a polymerizable monomer composition was prepared.

[Dispersion stabilizer preparation step]

After 710 parts of ion-exchanged water and 450 parts of 0.1 mol/L-sodium phosphate aqueous solution were added to a 2-L four-neck flask provided with a high-speed agitator T. K. Homo Mixer (produced by PRIMIX Corporation), heating to 60°C was performed under agitation at a rotational speed of 12,000 rpm. A water-based dispersion medium containing calcium phosphate serving as a fine, poorly-water-soluble dispersion stabilizer was prepared by adding 68.0 parts of 1.0 mol/L-calcium chloride aqueous solution thereto.

[Granulation·polymerization step]

The above-described polymerizable monomer composition was put into the above-described water-based dispersion medium, and granulation was performed for 15 min while a rotational speed of 12,000 rpm was maintained. Thereafter, the agitator was changed from the high-speed agitator to a propeller agitating blade, and the internal temperature was increased to 60°C and maintained so as to continue the polymerization reaction for 5 hours. Subsequently, the internal temperature was increased to 80°C and maintained so as to further continue the polymerization reaction for 3 hours. After the polymerization reaction was completed, a remaining monomer was removed by distillation at 80°C under reduced pressure. Subsequently, cooling to 30°C was performed so that a polymer fine particle dispersion liquid was obtained.

[Washing step]

The above-described polymer fine particle dispersion liquid was moved to a washing container, dilute hydrochloric acid was added under agitation so that the pH was adjusted to 1.5. After the dispersion liquid was agitated for 2 hours, solid-liquid separation was performed by using a filter so as to obtain a polymer fine particle. This was put into 1,200 parts of ion-exchanged water, and agitation was performed so as to form a dispersion liquid again. Thereafter, solid-liquid separation was performed by using a filter. This operation was performed three times so as to obtain a mother particle of a flow-passage-wall-forming particle T1.

[Fluidity improver attachment step]

Further, 1.0 part of fluidity improver (silica having a primary particle number average particle diameter of 7 nm) surface-treated with hexamethyldisilazane was added to 100.0 parts of the obtained mother particle, and dry mixing was performed for 5 min by using a Henschel mixer. As a result, a flow-passage-wall-forming particle T1 having a weight average particle diameter (D4) of 6.8 $\mu$m was obtained.

[Flow passage wall formation step]

A flow passage pattern illustrated in Fig. 5A to Fig. 5C was formed on the porous substrate S1 by using the flow-passage-wall-forming particle T1, and a micro flow passage device (Sample A) was formed through the heating process.

An oven (Forced Convection Constant Temperature Oven DN610H, Yamato Scientific Co., Ltd.) was used as the heating unit. The heating condition was set to be 15 min in a 160°C environment.

The cross section of the flow passage wall of the formed micro flow passage device was observed. The wax abundance ratio X on the surface side of the porous substrate was 5%, and the wax abundance ratio Y in the interior of the porous substrate was 95%.

The resulting micro flow passage device was subjected to a dripping test and a cracking-resistance evaluation test described below. The evaluation results are presented in Table 2.

In this regard, it was ascertained, as described below, that the flow passage wall in the porous substrate was formed of the wax and effectively functioned as the flow passage wall.

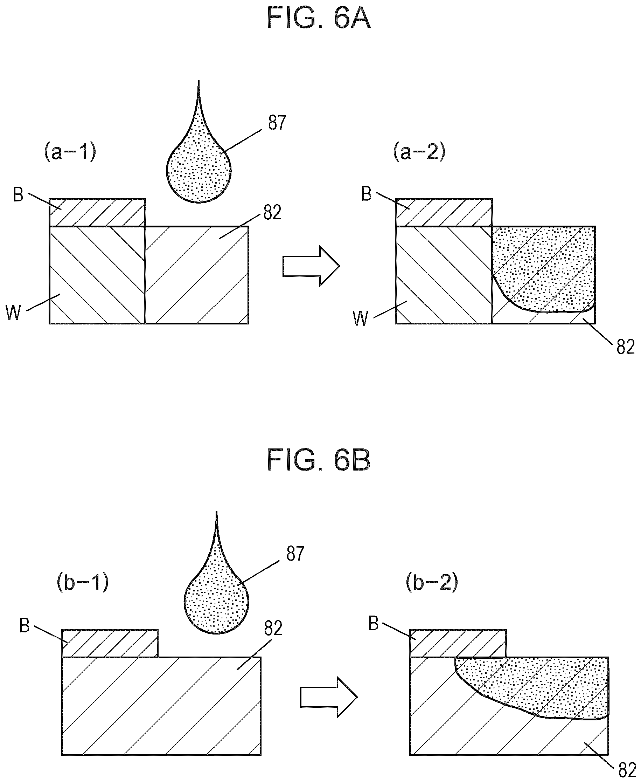

The wax was removed by dripping hexane to the formed micro flow passage device while suctioning was performed. Herein, since the thermoplastic resin does not dissolve in hexane and only the wax is eluted, only the wax is removed. The state of the device before washing with hexane is performed and the state of the device after washing is performed are illustrated in Fig. 6A and Fig. 6B, respectively.

Fig. 6A(a-1) and Fig. 6A(a-2) illustrate the state before the wax is removed by hexane. For example, colored water 87 in which a coloring agent such as a red food coloring is dripped to the flow passage 82 of the device (Fig. 6A(a-1)). When the flow passage wall formed of the wax W is present, soaking of the colored water into the flow passage wall side (under the thermoplastic resin B) does not occur due to the hydrophobicity of the wax (Fig. 6A(a-2)). Regarding the formed micro flow passage device, it was also ascertained that soaking of the colored water into the flow passage wall side (under the thermoplastic resin B) did not occur.

Fig. 6B(b-1) and Fig. 6B(b-2) illustrate the state after the wax is removed by hexane. When the colored water is dripped to the flow passage portion (Fig. 6B(b-1)) in the manner akin to that before the wax is removed, since the flow passage wall formed of the wax W was removed, soaking of the colored water 87 into the portion in which the flow passage wall was present (under the thermoplastic resin B) also occurs (Fig. 6B(b-2)). Regarding the formed micro flow passage device from which the wax was removed, it was also ascertained that soaking of the colored water into the flow passage wall side (under the thermoplastic resin B) occurred.

From these observation results, it was ascertained that the flow passage wall was formed of the wax and the wall effectively functioned as the flow passage wall.

<Dripping test>

The following specimen was dripped to the inspection liquid portion 84, and whether soaking of the specimen into the flow passage wall occurred was tested.

Specimen: red food coloring water produced by mixing the following composition was used as the specimen
Pure water (produced by using Pure Water System RO-HP150 produced by ORGANO CORPORATION): 40 mL
Kyoritsu Shokuhin K.K., Food Dye Red: 0.08 g

A micropipette was used, and 60 $\mu$L of red food coloring water was dripped. "OK" indicates that soaking was visually not observed. "NG" indicates that soaking was visually observed.

<Cracking resistance>

The device in which the flow passage wall is formed of only the wax has more improved cracking resistance than the device in which the thermoplastic resin is present in the flow passage wall material.

The formed micro flow passage device was wound around a circular column-like bar having a diameter of 10 mm, and the cracking resistance was examined. Herein, regarding winding, the device was wound with the surface outside. "OK" indicates that no visually observable crack occurred, and "NG" indicates that one or more visually observable crack occurred.

[Example 2]

A flow-passage-wall-forming particle T2 having a △SP value (= SP(B) - SP(W)) of 0.99 was formed in the manner akin to that of the flow-passage-wall-forming particle T1 except that the wax was changed to ethylene glycol dibehenate (weight average molecular weight of 707).
A micro flow passage device (Sample B) was produced in the manner akin to that in Example 1 except that the flow-passage-wall-forming particle T2 was used and that the heating time was changed to 60 min.
A dripping test and a cracking-resistance evaluation test were performed in the manner akin to that in Example 1. The results are presented in Table 2.

[Comparative example 1]

A flow-passage-wall-forming particle T3 having a △SP value (= SP(B) - SP(W)) of 0.58 was formed in the manner akin to that of the flow-passage-wall-forming particle T1 except that the wax was changed to ditetradecane terephthalate (weight average molecular weight of 587).
A micro flow passage device (Sample C) was produced in the manner akin to that in Example 2 except that the flow-passage-wall-forming particle T3 was used, and the sample was subjected to a dripping test and a cracking-resistance evaluation test. The results are presented in Table 2.

[Example 3]

In the present example, a micro flow passage device was produced by using a flow-passage-wall-forming particle T4 containing a thermoplastic resin B2 and a wax W4.
The thermoplastic resin B2 is a polyester synthesized using the following monomers.

·Bisphenol A-PO (propylene oxide) 2 mol adduct
50 parts by mass
·Bisphenol A-EO (ethylene oxide) 2 mol adduct
30 parts by mass
·Ethylene glycol
5 parts by mass
·Terephthalic acid
40 parts by mass

The wax W4 was FNP90 (NIPPON SEIRO CO., LTD., hydrocarbon wax, weight average molecular weight of 771)

·Thermoplastic resin B2
52 parts by mass
·Wax W4
48 parts by mass

The above-described materials were placed in a twin screw extruder (Model PCM-30, produced by Ikegai Corporation) set at a temperature of 120°, and kneading was performed so as to obtain a kneaded material.
The resulting kneaded product was cooled and crushed to 1 mm or less by using a hammer mill so as to obtain a crushed material. The resulting crushed material was pulverized by using a mechanical pulverizer (T-250, produced by Turbo Kogyo Co., Ltd.). Further, classification was performed by using a rotary classifier (200TSP, produced by Hosokawa Micron Corporation) so as to obtain a flow-passage-wall-forming particle T4 having a weight average particle diameter of 7.0 $\mu$m. Regarding the operation condition of the rotary classifier (200TSP, produced by Hosokawa Micron Corporation), classification was performed at the number of revolutions of a classification rotor of 50.0 $s^{-1}$.
A micro flow passage device (Sample D) was produced in the manner akin to that in Example 1 except that the flow-passage-wall-forming particle T4 was used and that the heating time was changed to 5 min, and a dripping test and a cracking-resistance evaluation test were performed. The results are presented in Table 2.

[Comparative examples 2 and 3]

A particle containing only the above-described wax W4 was prepared as a flow-passage-wall-forming particle T5. A micro flow passage device (Sample E) was produced in the manner akin to that in Example 1 except that the flow-passage-wall-forming particle T5 was used.

In addition, the wax FNP90 was removed from the composition of the flow-passage-wall-forming particle T1 so that a resin particle was formed as a flow-passage-wall-forming particle T6. A micro flow passage device (Sample F) was produced in the manner akin to that in Example 1 except that the flow-passage-wall-forming particle T6 was used.

A dripping test and a cracking-resistance evaluation test were performed in the manner akin to that in Example 1 except that the micro flow passage devices (Samples E and F) were used. The results are presented in Table 2.

[Example 4]

In example 4, a micro flow passage device was produced by using a flow-passage-wall-forming particle T7 containing the thermoplastic resin B1 and the wax W1.

A difference from Example 1 is that the flow-passage-wall-forming particle T7 in which the content of the wax W1 was changed from 20.0 parts by mass to 15.0 parts by mass was used.

A micro flow passage device (Sample G) was produced in the manner akin to that in Example 1, and a dripping test and a cracking-resistance evaluation test were performed. The results are presented in Table 2.

[Example 5]

In example 5, a micro flow passage device was produced by using a flow-passage-wall-forming particle T8 containing the thermoplastic resin B1 and a wax W5.

A difference from Example 1 is that FNP90 wax was changed to dioctadecyl terephthalate.

A micro flow passage device (Sample H) was produced in the manner akin to that in Example 1, and a dripping test and a cracking-resistance evaluation test were performed. The results are presented in Table 2.

[Table 2]

| | Example 1 | Example 2 | Comparative example 1 | Example 3 | Comparative example 2 | Comparative example 3 | Example 4 | Example 5 |
|---|---|---|---|---|---|---|---|---|
| Micro flow passage device | A | B | C | D | E | F | G | H |
| Flow-passage-wall-forming particle | T1 | T2 | T3 | T4 | T5 | T6 | T7 | T8 |
| Wax content (% by mass) | 16 | 16 | 16 | 48 | 100 | 0 | 13.1 | 16 |
| Difference in SP value $[cal/cm^3]^{1/2}$ | 1.41 | 0.99 | 0.58 | 1.41 | 0 | - | 1.41 | 0.69 |
| Wax abundance ratio — Surface side of porous substrate X | 5% | 6% | 14% | 26% | 100% | 0% | 3% | 14% |
| Wax abundance ratio — Interior of porous substrate Y | 95% | 95% | 62% | 99% | 100% | 0% | 96% | 68% |
| Dripping test | OK | OK | NG | OK | OK | NG | OK | OK |
| Cracking resistance evaluation test | OK | OK | OK | OK | NG | OK | OK | OK |

16

The present invention is not limited to the above-described embodiments and can be variously changed and modified without departing from the spirit and scope of the present invention. Therefore, to apprise the public of the scope of the present invention, the following claims are appended.

This application claims the benefit of Japanese Patent Application No. 2022-071208 filed April 23, 2022 and No. 2023-040811 filed March 15, 2023, which are hereby incorporated by reference herein in their entirety. Reference Signs List

| | |
|---|---|
| 4 | transfer roller |
| 5 | intermediate transfer body |
| 6 | primary transfer roller |
| 7 | secondary transfer roller |
| P | process cartridge |
| 11 | photosensitive drum |
| 12 | charge roller |
| 14 | cleaning blade |
| 15 | memory |
| 20 | developing apparatus |
| 21 | developing container |
| 23 | developing roller |
| 24 | resin particle supply roller |
| 25 | developing blade |
| 71 | charge high voltage |
| 72 | development high voltage |
| 73 | exposing unit |
| 74 | transfer high voltage |
| 75 | contact and separation means |
| 80 | flow passage pattern |
| 81 | protective layer |
| 82 | flow passage |
| 83 | reagent portion |
| 84 | inspection liquid portion |
| 100 | image-forming unit |
| T | flow-passage-wall-forming particle |
| B | thermoplastic resin |
| W | wax |

**Claims**

1. A micro flow passage device in which a flow passage interposed between a flow passage wall is formed in the interior of a porous substrate,

   wherein a flow-passage-wall-forming material constituting the flow passage wall contains a thermoplastic resin and a wax,

$$X < Y$$

   where an abundance ratio of the wax in the flow passage wall on the surface side of the porous substrate is denoted by X, and an abundance ratio of the wax present in a pore in the interior of the porous substrate is denoted by Y,
   a content of the wax in the total flow-passage-wall-forming material is 13.1% by mass or more and 70.0% by mass or less, and

$$SP(B) - SP(W) \geq 0.6$$

   where an SP value of the wax is denoted by $SP(W)$ $[cal/cm^3]^{1/2}$, and an SP value of the thermoplastic resin is denoted by $SP(B)$ $[cal/cm^3]^{1/2}$.

2. The micro flow passage device according to Claim 1,
   wherein the SP(W) and the SP(B) satisfy a following formula,

$$SP(B) - SP(W) \geq 1.0.$$

3. The micro flow passage device according to Claim 1 or Claim 2, wherein an weight average molecular weight of the wax is 300 or more and 10,000 or less.

4. A method for manufacturing a micro flow passage device in which a flow passage interposed between a flow passage wall is formed in the interior of a porous substrate, the method including:

   forming a flow passage pattern on a surface of the porous substrate by placing a flow-passage-wall-forming material containing a thermoplastic resin and a wax on the surface of the porous substrate by using an electrophotographic system; and
   forming a flow passage wall in the interior of the porous substrate by melting the wax contained in the flow passage pattern with heat so that the wax permeates the interior of the porous substrate,
   wherein a content of the wax in the total flow-passage-wall-forming material is 13.1% by mass or more and 70.0% by mass or less, and

$$SP(B) - SP(W) \geq 0.6$$

   where an SP value of the wax is denoted by SP(W) $[\text{cal/cm}^3]^{1/2}$, and an SP value of the thermoplastic resin is denoted by SP(B) $[\text{cal/cm}^3]^{1/2}$.

# FIG. 1A

# FIG. 1B

# FIG. 1C

# FIG. 2

# FIG. 3

FIG. 4

200 CONTROLLER

201 INTERFACE

202

155 CPU
15 MEMORY

71 CHARGE HIGH-VOLTAGE POWER SUPPLY
72 DEVELOPMENT HIGH-VOLTAGE POWER SUPPLY
73 EXPOSING UNIT
74 TRANSFER HIGH-VOLTAGE POWER SUPPLY
75 CONTACT AND SEPARATION MEANS
76 DEVELOPMENT PERIPHERAL SPEED

## FIG. 5A

## FIG. 5B

## FIG. 5C

# FIG. 6A

(a-1)

87

82

B

W

(a-2)

B

W

82

# FIG. 6B

(b-1)

87

82

B

(b-2)

B

82

## INTERNATIONAL SEARCH REPORT

International application No.

**PCT/JP2023/014591**

### A. CLASSIFICATION OF SUBJECT MATTER

***B81B 1/00***(2006.01)i; ***B81C 1/00***(2006.01)i; ***G01N 37/00***(2006.01)i; ***G03G 9/08***(2006.01)i; ***G03G 9/087***(2006.01)i; ***G03G 9/097***(2006.01)i

FI: B81B1/00; G01N37/00 101; B81C1/00; G03G9/08 391; G03G9/087 325; G03G9/087 331; G03G9/097 365

According to International Patent Classification (IPC) or to both national classification and IPC

### B. FIELDS SEARCHED

Minimum documentation searched (classification system followed by classification symbols)

B81B1/00; B81C1/00; G01N37/00; G03G9/08; G03G9/087; G03G9/097

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| X | JP 2021-37612 A (CANON KK) 11 March 2021 (2021-03-11) <br> paragraphs [0032]-[0036], [0039], [0047], [0054], [0058]-[0061], fig. 4-5 | 1-4 |
| A | JP 2017-45042 A (CANON KK) 02 March 2017 (2017-03-02) <br> paragraph [0094] | 1-4 |
| A | WO 2018/043237 A1 (TORAY INDUSTRIES, INC.) 08 March 2018 (2018-03-08) <br> paragraph [0289] | 1-4 |
| A | JP 2021-39095 A (CANON KK) 11 March 2021 (2021-03-11) <br> entire text, all drawings | 1-4 |

☐ Further documents are listed in the continuation of Box C.    ☑ See patent family annex.

\* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed

"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **30 May 2023** | **06 June 2023** |

| Name and mailing address of the ISA/JP | Authorized officer |
|---|---|
| **Japan Patent Office (ISA/JP)** <br> **3-4-3 Kasumigaseki, Chiyoda-ku, Tokyo 100-8915** <br> **Japan** | |
| | Telephone No. |

Form PCT/ISA/210 (second sheet) (January 2015)

INTERNATIONAL SEARCH REPORT
Information on patent family members

| | International application No. |
|---|---|
| | **PCT/JP2023/014591** |

| Patent document cited in search report | | | Publication date (day/month/year) | Patent family member(s) | | | Publication date (day/month/year) |
|---|---|---|---|---|---|---|---|
| JP | 2021-37612 | A | 11 March 2021 | US 2022/0177300 A1 paragraphs [0070]-[0085], [0091], [0112], [0123], [0129]-[0133], fig. 4-5 EP 4023589 A1 CN 114340776 A BR 112022002527 A2 | | | |
| JP | 2017-45042 | A | 02 March 2017 | US 2017/0060011 A1 paragraph [0151] | | | |
| WO | 2018/043237 | A1 | 08 March 2018 | US 2019/0194537 A1 paragraph [0294] CN 109661599 A KR 10-2019-0046795 A TW 201831649 A | | | |
| JP | 2021-39095 | A | 11 March 2021 | US 2022/0168731 A1 entire text, all drawings | | | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2012037511 A
- JP 2022071208 A
- JP 2023040811 A

**Non-patent literature cited in the description**

- **MAKI SHOTEN**. Kotingu no Kisokagaku (basic science of coating). 1986, 54-57